# EUROPEAN PATENT APPLICATION

(11) **EP 1 715 004 A1**
(43) Date of publication of application: **25.10.2006**
(21) Application number: 06007866.4
(22) Date of filing: 13.04.2006
(51) Int. Cl.: C08L 63/10, C09J 201/02, H01L 21/52

(54) **Die attach adhesives with improved stress performance**

(30) Priority: 18.04.2005 US 108398
(71) Applicant: National Starch and Chemical Investment Holding Corporation, New Castle, Delaware 19720 (US)
(72) Inventor: Eunsook, Chae, Long Beach California 90803 (US)
(74) Representative: Held, Stephan

(57) **Abstract**

Adhesive compositions containing a base compound or resin and an epoxy resin with vinyl functionality, without a curing agent for the epoxy resin, show enhanced stress performance. The compositions can be used in microelectronic applications.

## Description

### FIELD OF THE INVENTION

This invention relates to die attach adhesives with improved stress performance comprising a resin capable of cure by free-radical polymerization, a free radical curing agent, and an epoxy compound or resin with allyl or vinyl unsaturation, in which there is no curing agent for the epoxy compound.

### BACKGROUND OF THE INVENTION

Adhesive compositions are used for a variety of purposes in the fabrication and assembly of semiconductor packages, such as, the bonding of integrated circuit chips to leadframes or other substrates, stacked die assemblies, and the bonding of circuit packages or assemblies to printed wire boards. Major requirements for these uses are fast cure and high adhesive strength, traditionally achieved with epoxy resins. Epoxy resins, however, can be brittle, causing high stress in the package, and consequently, other resins have been evaluated and employed to promote flexibility and other properties, such as hydrophobicity. The alternate resins, however, do not always display the strong adhesion provided by the epoxy resins. Therefore, there is a need for die attach adhesives that incorporate a balance of properties to meet all the requirements for an adhesive used in the manufacture of a semiconductor package.

### SUMMARY OF THE INVENTION

This invention is an improvement on the invention disclosed in US Patent number 6,750,301 and is an adhesive composition comprising (a) a resin capable of cure by free-radical polymerization or hydrosilation, (b) an epoxy compound that contains allyl or vinyl unsaturation, (c) a curing agent for the resin, and (d) optionally, one or more fillers, characterized In that there is no curing agent for the epoxy resin present. As used in this specification and claims, a compound or resin capable of free-radical polymerization or cure is one containing carbon to carbon unsaturation, and a compound or resin capably of polymerization or cure by hydrosilation is one containing silicon-hydride groups. The composition may also contain adhesion promoters or coupling agents.

The inventor discovered that the removal of the curing agent for the epoxy compound gave an unexpected improvement in stress performance (as measured by warpage), while maintaining or improving adhesion, compared to the formulation containing curing agent for the epoxy. In another embodiment, this invention is a semiconductor package having a semiconductor die adhered to a substrate with the inventive adhesive.

### DETAILED DESCRIPTION OF THE INVENTION

Free-radical curable resins, which can be used as adhesives in microelectronic applications, include, for example, maleimides, such as those available from Ciba Specialty Chemicals; polyethers, such as those available from BASF; polyesters, such as those available from Uniqema or Bayer; poly(butadiene)s, such as those available from Elf-Atochern; polyurethanes, such as those available from Bayer or BASF; and acrylate resins, such as those available from Sartomer or UCB Radcure. The polyethers, polyesters, and polyurethanes preferably will contain terminal unsaturation, but may also contain unsaturation within the polymer chain.

Siloxanes and polysiloxanes, which cure by hydrosilation, may be linear or cylic polymers, and will have at least 2 silicone-hydride functionalities per molecule. Exemplary compounds are commercially available from Gelest;

The particular resin will be chosen by the practitioner to give specific material properties in a final formulation, such as, rheological properties, hydrophilic or hydrophobic properties, toughness, strength, or flexibility. The resin will be present in the adhesive composition in a range of 10-80% by weight.

The epoxy compounds may be any epoxy compounds with allyl or vinyl functionality. Examples include 2,6-digylcidylphenyl allyl ether, limonene dioxide, glycidyl vinyl benzyl ether or glycidyl vinyl ether. The epoxy will be present in the adhesive composition in a range of 0.1-30% by weight.

Exemplary free-radical initiators can be thermal- or photoinitiators and will be present in the adhesive composition in an amount of 0.1% to 10%, preferably 0.1% to 3.0%, by weight. Preferred thermal initiators include peroxides, such as di-(4-t-butyl cyclohexyl) peroxydicarbonate, butyl peroctoates and dicumyl peroxide, and azo compounds, such as 2,2'-azobis (2-methyl-propanenitrile) and 2,2'-azobis(2-methyl-butanenitrile). A preferred series of photoinitiator is one sold under the trademark Irgacure by Ciba Specialty Chemicals. In some formulations, both photo-cure and thermal cure may be desirable, for example, the curing process can be started by irradiation, and in a later processing step curing can be completed by the application of heat.

In general, these compositions will cure within a temperature range of 70°C to 250°C, and curing will be effected within a range of ten seconds to three hours. The time and temperature curing profile of each formulation will vary with the components of the formulation, but the parameters of a curing profile can be adjusted by a practitioner skilled in the art without undue experimentation.

In some compositions it may be desirable to add organic or inorganic fillers. Suitable conductive fillers are carbon black, graphite, gold, silver, copper, platinum, palladium, nickel, aluminum, silicon carbide, boron nitride, and alumina. Suitable nonconductive fillers are particles of vermiculite, mica, wollastonite, calcium carbonate, titania, sand, glass, fused silica, fumed silica, barium sulfate, and halogenated ethylene polymers, such as tetrafluoroethylene, trifluoroethylene, vinylidene fluoride, vinyl fluoride, vinylidene chloride, and vinyl chloride. When present, fillers will be in amounts of 20% to 90% by weight of the composition.

It may also be desirable to add adhesion promoters or coupling agents, including sllanes, silicate esters, metal acrylates or methacrylates, titanates, and compounds containing a chelating ligand, such as phosphine, mercaptan, and acetoacetate. When present, these materials will be in amounts up to 10% by weight, and preferably in amounts of 0.1 % to 3.0% percent by weight of the composition.

The invention is further illustrated by the following examples, which are not intended as a limitation on the invention.

### EXAMPLES

For these examples the adhesion strength of a semiconductor die to a substrate was measured as die shear strength In Kg force. The tests were conducted using unencapsulated assemblies of a 3 x 3 mm silicon die attached to a two-layer BT printed circuit board. The unencapsulated assemblies were cured in an oven with a 30 minute ramp from room temperature to 175°C followed by a 15 minute hold at 175°C. The assemblies were then separated into two groups. One group was tested for die shear strength directly after cure (post cure). A second group was exposed to a simulation of post-mold baking for four hours at 175°C and were then returned to room temperature and tested for die shear strength (post mold bake). Both the post cure and post mold bake groups were further divided into two sub-groups, where the first sub-group was tested for die shear strength at room temperature and the second sub-group was tested for die shear strength at 260°C. All of the assemblies exhibited cohesive mode of failure of the adhesive adhering the die to the substrate.

The level of stress present in the package is indicated by warpage of the die in an unencapsulated assembly. Higher warpage values indicate higher stress In the die attach assembly. For these examples two types of assemblies were tested. In the first type a 12.7 x 12.7 x 0.38 mm silicon die was attached to a 0.2 mm thick silver-plated copper leadframe. In the second type a 7 x 8 x 0.076 mm silicon die was attached to a 0.2 mm thick bismaleimide triazine (BT) substrate. The assembly was cured in an oven with a 30 minute ramp from room temperature to 175°C followed by a 15 minute hold at 175°C. The assemblies were then returned to room temperature and the warpage of the die was measured using a surface roughness-measuring instrument.

In the following examples, formulations with and without the curing agent for the epoxy with allyl or vinyl functionality were tested for room temperature and hot dry die shear strength (measured in kg of force), and for warpage (measured in µm) using the above described protocols. The adhesive composition and performance test data are set out in the following tables and show that the adhesive formulations without the curing agent for the epoxy with allyl or vinyl functionality had equivalent or higher die shear strength and lower warpage. Therefore, the data indicate that the formulations without the curing agent for the epoxy compound with vinyl or allyl unsaturation unexpectedly improve adhesive performance. The compositions are reported in weight percent.

EXAMPLE 1

| COMPOSITION Ex.1 | Without curing agent for epoxy compound | With curing agent for epoxy compound |
|---|---|---|
| Proprietary Bismaleimide | 26.57% | 26.51% |
| Di-(4-t-butyl cyclohexyl) Peroxydicarbonate | 0.53 | 0.53 |
| Di-trimethylopropane tetraacrylate | 3.99 | 3.97 |
| 2-Phenoxyethyl acrylate | 7.97 | 7.95 |
| Poly(budadiene) | 5.31 | 5.30 |
| 40% CTBN in Bisphenol F epoxy resin | 3.99 | 3.98 |
| (2,6-Diglycidylphenyl allyl ether) epoxy resin | 6.64 | 6.63 |
| 2-Ethyl-4-methyl imidazole-CN | 0 | 0.13 |
| Silica 1 | 30 | 30 |
| Silica 2 | 15 | 15 |
| Total | 100% | 100% |

| Performance Ex 1 | | |
|---|---|---|
| Die Warpage @ Room Temp. Post cure, SPCLF | 7.7µm | 20.7µm |
| Die Shear Strength Post cure, @ room temp. | 8.3 | 10.6 |
| Post cure, @ 260°C | 1.7 | 1.6 |
| Post mold bake, @ room temp. | 23.3 | 24.9 |
| Post mold bake, @ 260°C | 5.3 | 5.8 |

EXAMPLE 2

| COMPOSITION Ex.2 | Without curing agent for epoxy compound | With curing agent for epoxy compound |
|---|---|---|
| Proprietary Bismaleimide | 28.65% | 28.58% |
| Di-(4-t-butyl cyclohexyl) peroxydicarbonate | 0.57 | 0.57 |
| Di-trimethylopropane tetraacrylate | 4.30 | 4.29 |
| 2-phenoxyethyl acrylate | 8.59 | 8.57 |
| poly(budadiene) | 5.73 | 5.71 |
| (2,6-diglycidylphenyl allyl ether) epoxy resin | 7.16 | 7.14 |
| 2-ethyl-4-methyl imidazole-CN | 0 | 0.14 |
| Silica 1 | 30 | 30 |
| Silica 2 | 15 | 15 |
| Total | 100% | 100% |

| Performance Ex 2 | | |
|---|---|---|
| Die Warpage @ Room Temp. | | |
| Post cure, SPCLF | 12.3µm | 26.7µm |
| Die Shear Strength temp. | 11.7 | 9.1 |
| Post cure, @ room | | |
| Post cure, @ 260°C | 1.8 | 1.6 |
| Post mold bake, @ room temp. | 22.4 | 25.6 |
| Post mold bake, @ 260°C | 3.8 | 4.0 |

EXAMPLE 3

| COMPOSITION Ex.3 | Without curing agent for epoxy compound | With curing agent for epoxy compound |
|---|---|---|
| Proprietary Bismaleimide | 43.30% | 43.14% |
| Di-(4-t-butyl cyclohexyl) peroxydicarbonate | 0.89 | 0.86 |
| (2,6-Diglycidylphenyl allyl ether) epoxy resin | 10.82 | 10.78 |
| 2-Ethyl-4-methyl imidazole-CN | 0 | 0.22 |
| Silica 1 | 30 | 30 |
| Silica 2 | 15 | 15 |
| Total | 100% | 100% |

| Performance Ex 3 | | |
|---|---|---|
| Die Warpage @ Room Temp. Post cure, SPCLF | 1.0 | 3.2 |
| Post cure, BT | 3.8 | 8.5 |
| Die Shear Strength Post cure, @ room temp. | 10.0 | 0.3 |
| Post cure, @ 260°C | 2.5 | 0.2 |
| Post mold bake, @ room temp. | 18.6 | 7.5 |
| Post mold bake, @ 260°C | 4.1 | 1.7 |

EXAMPLE 4

| COMPOSITION Ex.4 | Without curing agent for epoxy compound | With curing agent for epoxy compound |
|---|---|---|
| proprietary bismaleimide | 35.03% | 34.92% |
| Di-(4-t-butyl cyclohexyl) Peroxydicarbonate | 0.70 | 0.70 |
| 2-phenoxyethyl acrylate | 10.51 | 10.48 |
| (2,6-diglycidylphenyl allyl ether) epoxy resin | 8.76 | 8.73 |
| 2-ethyl-4-methyl imidazole-CN | 0 | 0.17 |
| Silica 1 | 30 | 30 |
| Silica 2 | 15 | 15 |
| Total | 100% | 100% |

| Performance Ex 4 | | |
|---|---|---|
| Die Warpage @ Room Temp. Post cure, SPCLF | 1.7 | 2.0 |
| Post cure, BT | 4.8 | 8.8 |
| Die Shear Strength Post cure, @ room temp. | 7.5 | 1.2 |
| Post cure, @ 260°C | 1.8 | 0.4 |
| Post mold bake, @ room temp. | 15.1 | 8.6 |
| Post mold bake, @ 260°C | 2.9 | 1.7 |

EXAMPLE 5

| COMPOSITION Ex.5 | Without curing agent for epoxy compound | With curing agent for epoxy compound |
|---|---|---|
| Proprietary Bismaleimide | 35.03 | 34.92 |
| Di-(4-t-butyl cyclohexyl) peroxydicarbonate | 0.70 | 0.70 |
| Di-trimethylopropane tetraacrylate | 10.51 | 10.48 |
| (2,6-Diglycidylphenyl allyl ether) epoxy resin | 8.76 | 8.73 |
| 2-Ethyl-4-methyl imidazole-CN | 0 | 0.17 |
| Silica 1 | 30 | 30 |
| Silica 2 | 15 | 15 |
| Total | 100% | 100% |

| Performance Ex 5 | | |
|---|---|---|
| Die Warpage @ Room Temp. Post cure, SPCLF | 3.1 | 6.8 |
| Post cure, BT | 15.5 | 15.5 |
| Die Shear Strength Post cure, @ room temp. | 11.3 | 9.0 |
| Post cure, @ 260°C | 2.5 | 1.4 |
| Post mold bake, @ room temp. | 17.7 | 18.0 |
| Post mold bake, @ 260°C | 4.0 | 2.8 |

EXAMPLE 6

| COMPOSITION Ex.6 | Without curing agent for epoxy compound | With curing agent for epoxy compound |
|---|---|---|
| Proprietary Bismaleimide | 14.13% | 14.08% |
| Di-(4-t-butyl cyclohexyl) peroxydicarbonate | 0.28 | 0.28 |
| Di-trimethylopropane tetraacrylate | | |
| 2-Phenoxyethyl acrylate | 4.24 | 4.23 |
| Poly(budadiene) | 2.82 | 2.82 |
| (2,6-Diglycidylphenyl allyl ether) epoxy resin | 3.53 | 3.52 |
| 2-ethyl-4-methyl imidazole-CN | 0 | 0.07 |
| Silver flake | 75 | 75 |
| Total | 100% | 100% |

| Performance Ex 6 | | |
|---|---|---|
| Die Warpage @ Room Temp. Post cure, SPCLF | 15.5 | 19.8 |
| Post cure, BT | 22.5 | 23.5 |
| Die Shear Strength Post cure, @ room temp. | 9.7 | 8.7 |
| Post cure, @ 260°C | 2.5 | 3.0 |
| Post mold bake, @ room temp. | 13.1 | 17.9 |
| Post mold bake, @ 260°C | 4.2 | 3.8 |

## Claims

1. A die attach adhesive composition comprising:
(a) a resin capable of curing by free-radical polymerization or by hydrosilation, present in an amount of 10% to 80% by weight,
(b) an epoxy compound having vinyl or allyl functionality, present in an amount of 0.1 % to 30% by weight,
(c) a curing agent for the resin (a), present in an amount of 0.1% to 10% by weight, and
(e) optionally, a filler, present in an amount of 20% to 90% by weight; **characterized in that** there is no curing agent for the epoxy compound present.

2. The die attach adhesive according to claim 1 in which the resin is selected from the group consisting of maleimides, polyethers, polyesters, poly(butadiene)s, polyurethanes, acrylates, siloxanes, and polysiloxanes.

3. The die attach adhesive according to claim 1 in which the epoxy compound is selected from the group consisting of 2,6-digylcidylphenyl allyl ether, limonene dioxide, glycidyl vinyl benzyl ether, and gylcidyl vinyl ether.

4. The die attach adhesive according to claim 1 in which the filler is present and is selected from the group consisting of carbon black, graphite, gold, silver, copper, platinum, palladium, nickel, aluminum, silicon carbide, boron nitride, diamond, alumina, vermiculite, mica, wollastonite, calcium carbonate, titania, sand, glass, fused silica, fumed silica, barium sulfate, tetrafluoroethylene, trifluoroethylene, vinylidene fluoride, vinyl fluoride, vinylidene chloride, and vinyl chloride.
